# EUROPEAN PATENT SPECIFICATION

(11) **EP 2 503 605 B1**
(45) Date of publication and mention of the grant of the patent: **20.07.2016**
(21) Application number: 11825446.5
(22) Date of filing: 15.09.2011
(51) Int. Cl.: H01L 33/00

(54) **LIGHT-EMITTING DIODE AND METHOD FOR PRODUCING SAME**
LICHTEMITTIERENDE DIODE UND VERFAHREN ZU IHRER HERSTELLUNG
DIODE ÉLECTROLUMINESCENTE ET PROCÉDÉ DE PRODUCTION DE CELLE-CI

(30) Priority: 15.09.2010 KR 20100090632
(43) Date of publication of application: 26.09.2012
(73) Proprietor: Lightizer Korea Co., Ltd, Gangnam-gu, Seoul 135-010 (KR)
(72) Inventor: CHO, Byoung-Gu, Seoul 136-904 (KR)
(74) Representative: Appleyard Lees IP LLP
(86) International application number: PCT/KR2011/006817
(87) International publication number: WO 2012/036486

(56) References cited:
- DE-A1-102006 026 481
- JP-A- 2008 514 027
- JP-A- 2009 260 244
- JP-A- 2009 272 638
- JP-A- 2010 103 349
- KR-A- 20050 042 005
- US-A1- 2004 004 434
- US-A1- 2007 111 344
- US-A1- 2010 123 386
- US-A1- 2010 219 433
- US-B1- 6 395 564

## Description

### TECHNICAL FIELD

The present disclosure relates to a light emitting diode and a method of manufacturing the same, and more particularly, to a light emitting diode emitting white light and a method of manufacturing the same.

### BACKGROUND ART

Light emitting diodes (LEDs) are energy efficient products and the use of the LEDs has been increased, and research and development of the LEDs have been continued. In this aspect, white light emitted from the light emitting diode is required, but realization of white light is not facilitated. Various new methods for realizing white light have been attempted in the past.

However, such various approaches were performed at a chip level instead of a wafer level and these approaches may cause a waste of chips.

Further, none of the existing approaches may change a ratio of a phosphor (fluorescent substance) based on the result of fundamental measurement such as a wavelength of emitted light.

Therefore, there is a need for a light emitting diode according to a new approach and a method of manufacturing the same.

### DISCLOSURE OF THE INVENTION

### TECHNICAL PROBLEM

Embodiments provide a light emitting diode emitting high-yield white light and a method of manufacturing the same.

Embodiments also provide a light emitting diode emitting white light able to reduce manufacturing costs and a method of manufacturing the same.

Embodiments also provide a light emitting diode able to output identical target white lights in a color coordinate system and a method of manufacturing the same.

### TECHNICAL SOLUTION

In one embodiment, a method of manufacturing a light emitting diode includes: measuring a light emitting diode at a wafer level; and performing conformal coating on the light emitting diode with a material having a phosphor mixing ratio based on the measured result, wherein the measuring comprises measuring a wavelength of light emitted by the light emitting diode, to convert light emitted from the light emitting diode to white light and the light emitting diode being multiply coated with phosphor material, each coat having different phosphor mixing ratios of yellow, green and phosphors.

Also, the light emitting diode may include at least any one of a blue light emitting diode or an ultraviolet light emitting diode.

The method may further include treating a region of the light emitting diode on which the conformal coating is performed to prevent the coating penetrating the region.

Further, the region may be separated by using at least any one of a paraffin wax, a silk screen, and a photoresist.

In further another embodiment, a light emitting diode includes: a light emitting part; and a conformal coating part coated on the light emitting part and having a phosphor mixing ratio based on a wavelength of light emitted from the light emitting part to convert the light emitted from the light emitting part to white light and the light emitting diode being configured to be multiply coated with phosphor material, each coat having different phosphor mixing ratios of yellow, green and red phosphors.

### ADVANTAGEOUS EFFECTS

A method of manufacturing a white light emitting diode in the present invention allows a manufacturing process of a white light emitting diode to be performed at a wafer level different from a chip-level packing method and wavelength data for each unit chip are measured in advance at a wafer level to accurately control a mixing ratio of phosphors (yellow: Y, green: G, and red: R) for a corresponding wavelength of the each unit chip and dispense a phosphor for each chip on the wafer.

A conformal coating method, in which a predetermined coating thickness is obtained on a chip surface, may have the following effects.

First, since a phosphor+Si material for converting to the same target white color in a color coordinate system is determined for each unit chip at a wafer level to coat on each chip, a color deviation of white light emitted for each chip may decrease. Thus, a white light diode processing yield may increase.

Second, a design margin may increase during design of an optical lens using each white light emitting diode chip due to the minimization of a color deviation.

Third, since a phosphor coating process is performed on each chip at a wafer level, a sorting process, in which LEDs having wavelengths within a similar range are sorted for each chip, is not required. Also, since a white color coordinate is already obtained at a wafer level instead of a packaging level, a separate packaging process may not be required and additional material costs may not be generated.

Fourth, since a white light chip is manufactured at a wafer level, production equipment investment may decrease and costs for managing white light diode chips may be reduced. In particular, equipments for performing a packaging process, such as a sorting equipment for sorting, may not be required.

Fifth, since a white light diode chip is completed for each chip at a wafer level, typical processes, such as separate die attach, wiring, and phosphor coating, may be omitted when chip on module (COM) and chip on board (COB) using a flip chip method are used. Therefore, processing costs and material costs may be reduced.

### BRIEF DESCRIPTION OF THE DRAWINGS

Fig. 1 is a chip wavelength distribution graph in a light emitting diode wafer.
Fig. 2 is a color coordinate system and a table illustrating chip wavelengths measured with respect to chip types 1, 2, and 3 for realizing white light having the same color coordinate and corresponding phosphor+Si mixing ratios.
Fig. 3 is a schematic view illustrating a phosphor coating method at a packaging level.
Fig. 4 is a schematic view illustrating a conformal coating mode performed on each chip at a wafer level in a method of manufacturing a light emitting diode of the present invention.
Fig. 5 is a schematic view illustrating conformal coating in a method of manufacturing a light emitting diode according to a first embodiment of the present invention.
Fig. 6 is a schematic view illustrating conformal coating in a method of manufacturing a light emitting diode according to a second embodiment of the present invention.
Fig. 7 is a schematic view illustrating conformal coating in a method of manufacturing a light emitting diode according to a third embodiment of the present invention.
Fig. 8 is a flowchart schematically illustrating a method of manufacturing a light emitting diode according to a fourth embodiment of the present invention.

### MODE FOR CARRYING OUT THE INVENTION

As described above, the present invention relates to a light emitting diode able to emit white light and a method of manufacturing the same. More particularly, a wavelength of light emitted from a light emitting diode (LED) (e.g., blue LED or ultra-violet LED) is measured at a wafer level.

Conformal coating is performed on the LED based on the result of wavelength measurement. The conformal coating has a phosphor mixing ratio based on the wavelength. Also, the phosphor mixing ratio includes the colors yellow, green, and red. Accordingly, light emitted from the LED is converted to white light by using conformal coating. In embodiments, the foregoing operations are performed at a wafer level and thus, better uniformity and consistency may be obtained.

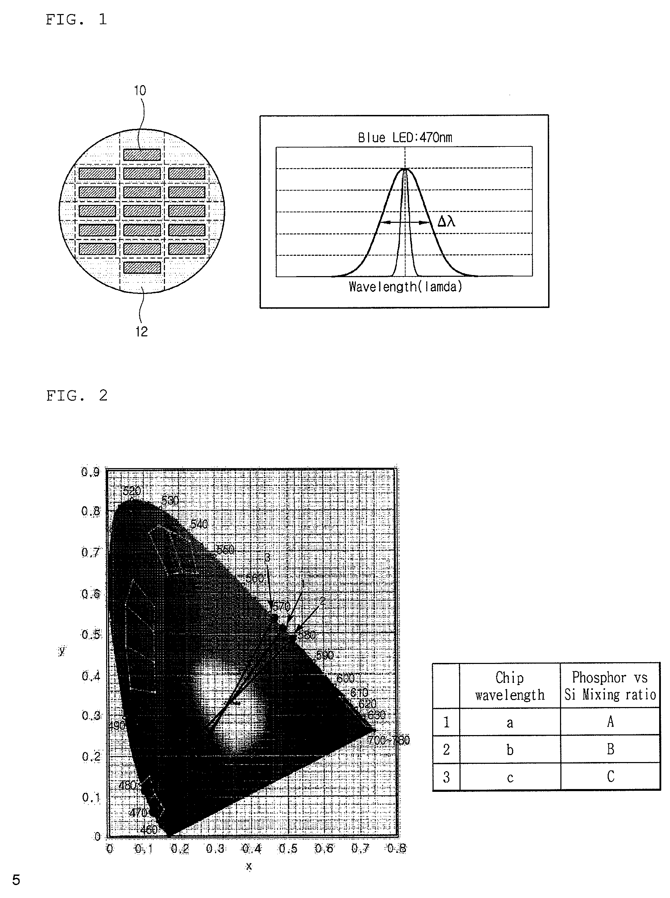

Meanwhile, a wavelength distribution may exist between each chip in a LED wafer due to process deviation and equipment deviation in a metal organic chemical vapor deposition (MOCVD) process among epitaxial (EPI) processes of the LED chip. Fig. 1 is the result of measuring wavelengths of blue light for chips 10 in an arbitrary LED wafer 12. The chips 10 in the wafer 12 do not have the same single wavelength but have the wavelength distribution between the chips 10. In general, when a wavelength difference between the chips 10 is generated in an amount of 5 nm or more, the difference may be visually recognized.

Fig. 2 shows a RGB color coordinate system. When the same phosphor is overall applied at a wafer level in order to convert the chips 10 on the same wafer 12 to white light in a state of having the wavelength distribution between the chips 10 in the same wafer 12 as in Fig. 1, a white color coordinate may change for the each chip. Therefore, white light having the same white color coordinate may be obtained by only using different phosphor mixing ratios according to the wavelength of each individual chip 10.

Blue portion number 1 in a color coordinate system of Fig. 2 denotes a case in which the wavelength of the chip is a, and in this case, a mixing ratio of yellow, red, and green (Y, R, G) phosphors of A must be used to form a target white color coordinate. Also, when the wavelengths of the chips are respectively b and c as in numbers 2 and 3, the mixing ratios of phosphors of B and C different from A must be respectively used to form the same target white color coordinate as in number 1. Herein, the phosphors having the foregoing mixing ratios may be mixed together with silicon (Si).

When a fluorescent layer having the same mixing ratio A of phosphor and silicon is used for the chips having different wavelengths of a, b, and c, three chips may have different target white color coordinates. When the white color coordinate changes, color distribution occurs, and thus, product configuration may be difficult when the LEDs are used in a back light unit (BLU) used in a liquid crystal display (LCD) device and lighting. According to the foregoing limitation, a process of coating the phosphor is performed at an individual chip level during a LED package (PKG) process instead of a wafer level and a process of sorting (ranking) the individual chips by the wavelength of blue light emitted from each chip is performed before the process of coating the phosphor.

However, when the phosphor coating is performed on each individual chip during a packaging process, this may be a major factor of increasing product costs, because the sorted individual chips must be stored and maintained in addition to the foregoing sorting process and a process sequence increases and becomes complicated.

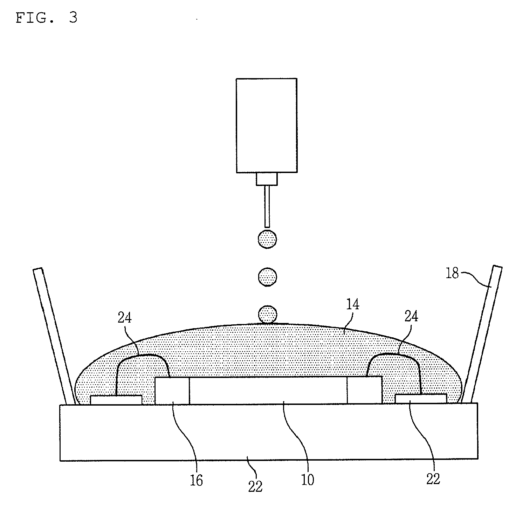

Fig. 3 schematically illustrates a process of coating a phosphor at each individual chip level. First, in a lead frame 16 having a cup 18, a LED chip 10 is attached to the center of the cup 18, and a metal pad 20 of the LED chip 10 and an electrode line 22 of the lead frame 16 are bonded to each other by a wire 24. In order to form a target white color coordinate, a coating layer 24 (a phosphor+Si material) designed according to the wavelength of a corresponding chip is dispensed on a surface of the LED chip 10.

The above-described phosphor coating technique at a chip level has a few limitations.

First, since a thickness of the phosphor+Si material (a minimum of 300 µm or more) is high, an optical mean free path changes according to a surface position of the LED chip and thus, a color deviation may occur (LED binning). The occurrence of the color deviation results in a lot of limitations during an optical design.

Second, since the process of coating a phosphor is not performed at a wafer level but performed at a chip level, separate package material and processing costs may additionally occur in addition to the cost of the chip, when defects are generated due to a deviation of white color coordinate after packaging.

Third, a sorting process for the same wavelength range with respect to the wavelength distribution of the chips in a wafer is accompanied in advance in order to perform chip-level coating, and in this case, processing time may be extended and equipment investment costs may occur. When the phosphor coating process is performed on each unit chip at a wafer level, the separate sorting process is not required and the white color coordinate may be obtained in advance at a wafer level instead of a package level. Therefore, separate package processing and material costs may not additionally occur during the generation of defect chips.

As described above, the method of manufacturing a white light emitting diode according to the present invention allows a manufacturing process of a white light emitting diode to be performed at a wafer level different from a chip level packaging method. In particular, wavelength data for the each unit chip are measured in advance at a wafer level, the foregoing relatively lower level, to accurately determine a mixing ratio of phosphors (yellow: Y, green: G, and red: R) appropriate for the measured wavelength in order to convert the corresponding wavelength of the each unit chip into the same target white light. Then, a conformal coating layer is formed for the each unit chip in such a manner that a phosphor having the determined mixing ratio is dispensed on the each unit chip at a wafer level. Therefore, a thickness of the fluorescent material conformal coating layer may be relatively lower in comparison to that obtained when the coating is performed at a chip level.

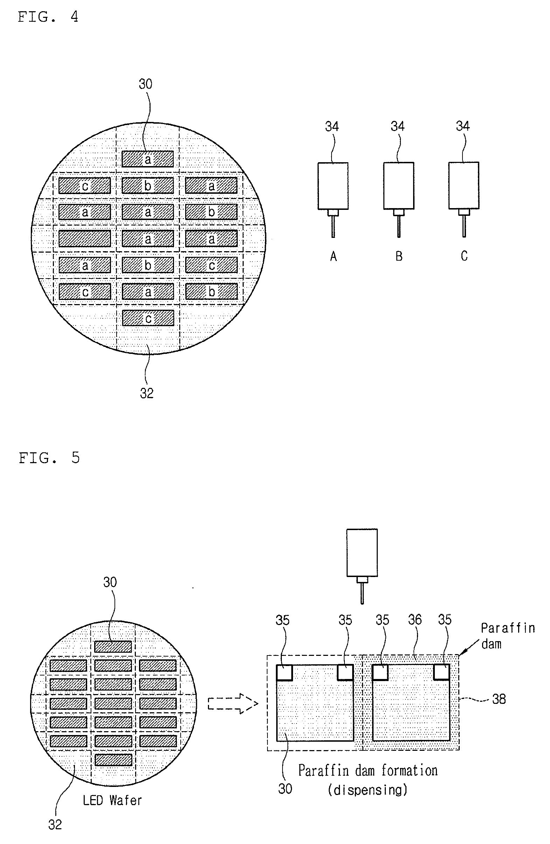

Fig. 4 schematically illustrates a fluorescent material coating process in the method of manufacturing a light emitting diode, which is commonly applied to the present invention. In order to realize the same white color coordinate with respect to entire chips 30 in a wafer 32, an appropriate phosphor mixing ratio to be used on the each unit chip 30 is determined based on the result of measuring wavelengths of the entire chips 30. For example, when the wavelengths are a, b, and c, mixing ratios may be A, B, and C, respectively. Three identical dispensers 34A, 34B, and 34C are prepared for the foregoing three types or more of mixing ratios and each dispenser includes a phosphor having a different mixing ratio. As shown in Fig. 4, the plurality of dispensers 34A to 34C dispense a corresponding phosphor+Si material (hereinafter, referred to as "fluorescent substance") on the each unit chip at a wafer level to form a conformal phosphor coating layer on the chip. As a result, a white LED emitting white light may be obtained through the phosphor coating at a wafer level.

Herein, the LED chips 30 on the wafer 32 before being coated with the fluorescent substance may be denoted as a light emitting part. The light emitting part is composed of an N layer, a P layer, and an active layer, and the foregoing configuration is already known so that detailed description will not be provided.

Herein, the meaning of "a wafer level" denotes a stage of the wafer before the each unit LED chip 30 formed on the wafer is diced and separated.

As the number of the dispensers increases, coating of a fluorescent substance having a more accurate mixing ratio on the individual unit chip having various wavelength distributions formed at a wafer level may be possible.

In the embodiments of the invention, each unit chip at a wafer level is coated with a fluorescent substance having an arbitrary mixing ratio by using the foregoing plurality of dispensers 34A to 34C. More particularly, a single unit chip is multiply coated with fluorescent substances having different mixing ratios by using at least two or more dispensers among the plurality of dispensers 34A to 34C and thus, the desired fluorescent substance having an arbitrary mixing ratio is coated. That is, the multiply coated fluorescent substances finally become a desired fluorescent layer having an arbitrary mixing ratio.

Hereinafter, three embodiments are suggested in the present invention, in which a phosphor+Si material (fluorescent substance) is independently coated for the each unit chip 30 at a wafer level.

The first embodiment is illustrated in Fig. 5.

In this case, a material containing paraffin 36 (other materials may be contained) is printed on a scribe line between a chip 30 and a chip 30 in a wafer 32. Thus, coating of the fluorescent substance on the scribe line may be prevented. Next, the material containing paraffin 36 is also printed on a metal pad 35 portion along a pad line to prevent the fluorescent substance of phosphor+Si to be dispensed by a dispenser from penetrating the metal pad 35 portion. In this case, when the material such as paraffin is printed, a thickness of the fluorescent material coating layer is about 100 µm. A major function of the paraffin material is to act as a guide dam 38 which prevents flow of the fluorescent substance to coat on the chip 30 and contains the fluorescent substance inside the guide dam 38.

A method of manufacturing a light emitting diode according to the present invention is described below.
(1) A wavelength of each diode chip 30 is measured at a wafer level;
(2) A mixing ratio of phosphor (Y, G, and B) and Si corresponding to a target white color coordinate for a group of the measured wavelengths is determined;
(3) As illustrated in Fig. 5, a guide dam 38 is formed by printing a material such as paraffin 36 on scribe lines and metal pad 35 portions in the each chip 30 in a wafer 32;
(4) In order to realize a target white color coordinate, a fluorescent substance, which is formed of phosphor having a corresponding mixing ratio with respect to the wavelength of the each chip 30 in the wafer 32 and a silicon material for bonding the phosphor onto the chip 30, is coated;

Herein, the fluorescent substance containing the phosphor having a predetermined mixing ratio and the silicon material may be dispensed through the foregoing plurality of dispensers (34A to 34C in Fig. 4).
(5) The phosphor+Si material is hard cured in an oven;
(6) Next, the chip 30 coated with the fluorescent substance on the wafer 32 is diced along the scribe lines.

Herein, it was described in Fig. 5 that the scribe line may be formed for the individual chip 30. However, when the fluorescent material coating may be simultaneously performed on two chips 30 by one dispenser as in the case that the fluorescent substance coating is possible by the same dispenser because a wavelength distribution is within an error range, a scribe line may also be formed in a shape surrounding the two chips 30 as needed.

If necessary, when the fluorescent material coating is possible by one dispenser because three or more adjacent chips 30 have a wavelength distribution within an error range, a scribe line may be formed to surround the three or more adjacent chips 30.

Also, between the foregoing operations (3) and (4), an operation of distinguishing which dispenser must be used to coat the fluorescent substance on the individual chip 30 from the measured wavelength data of the individual chips 30 on the wafer 32 may be further included. That is, since the wavelength distribution between the individual chips 30 may variously occur, a range of the wavelength distribution compensable by each dispenser may be determined in order to dispense the fluorescent substances by limited dispensers. For example, a range of wavelength a for coating a fluorescent substance by dispenser A may be 10 nm.

Herein, when a predetermined phosphor mixing ratio is already determined for each of the plurality of dispensers, the foregoing operation (2) may be replaced by an operation of distinguishing which dispenser among the plurality of dispensers is suitable for the individual chip 30 from the measured wavelength data of the individual chips 30 on the wafer 32 through operation (1).

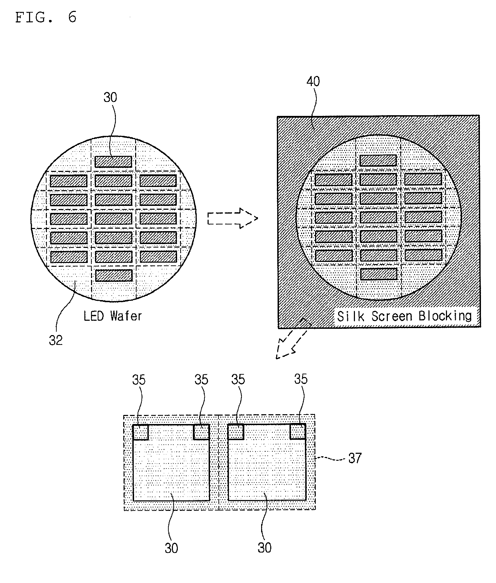

The second embodiment of the present invention is described with reference to Fig. 6 below.

In this case, a scribe line between a chip 30 and a chip 30 and metal pad portions 35 may be blocked by a silk screen 40 or a metal mask 40 to prevent a fluorescent substance of phosphor+Si to be dispensed from penetrating. The blocking is performed and the phosphor+Si material is then dispensed by using a dispensing method according to the wavelength of each unit chip at a wafer level. The method of manufacturing a light emitting diode according to the present invention is described in more detail below.
(1) A wavelength of each configured diode chip is measured at a wafer level;
(2) A mixing ratio of phosphor (Y, G, and B) and Si corresponding to a target white color coordinate for a group of the measured wavelengths is determined;
(3) As illustrated in Fig. 6, scribe lines and metal pad 35 portions in the each chip in a wafer are blocked by using a silk screen 40;
(4) In order to realize a target white color coordinate, a fluorescent substance, which is formed of a phosphor having a corresponding mixing ratio with respect to the wavelength of the each chip and a silicon material, is coated on the each chip;
(5) The phosphor+Si material is temporarily cured;
(6) The silk screen and/or metal mask block are removed;
(7) The fluorescent substance of phosphor+Si is hard cured in an oven.

Herein, in some cases, the foregoing temporary curing operation (5) may be omitted.

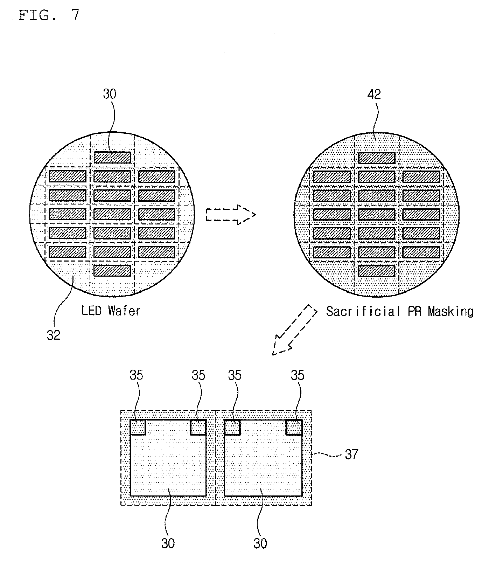

The third embodiment of the present invention is described with reference to Fig. 7 below.

In this case, a scribe line 37 between a chip 30 and a chip 30 and metal pad 35 portions may be masked by a sacrificial layer 42 of a photoresist (PR) and/or an organic material to prevent a dispensed fluorescent substance of phosphor+Si from penetrating. The masking is performed and the fluorescent substance of phosphor+Si is then dispensed by using a dispensing method according to the wavelength of each unit chip at a wafer level. The method of manufacturing a light emitting diode according to the present embodiment is described in more detail below.
(1) A wavelength of each configured diode chip is measured at a wafer level;
(2) A mixing ratio of phosphor (Y, G, and B) and Si corresponding to a target white color coordinate for a group of the measured wavelengths is determined;
(3) As illustrated in Fig. 7, scribe lines and metal pad portions in the each chip in a wafer are masked by using the sacrificial layer or the like;
(4) In order to realize a target white color coordinate, a fluorescent substance of phosphor and silicon having a corresponding mixing ratio with respect to the wavelength of the each chip is coated;
(5) The fluorescent substance of phosphor+Si is hard cured in an oven;
(6) The sacrificial layer PR on the scribe lines and the metal pad portions is removed.

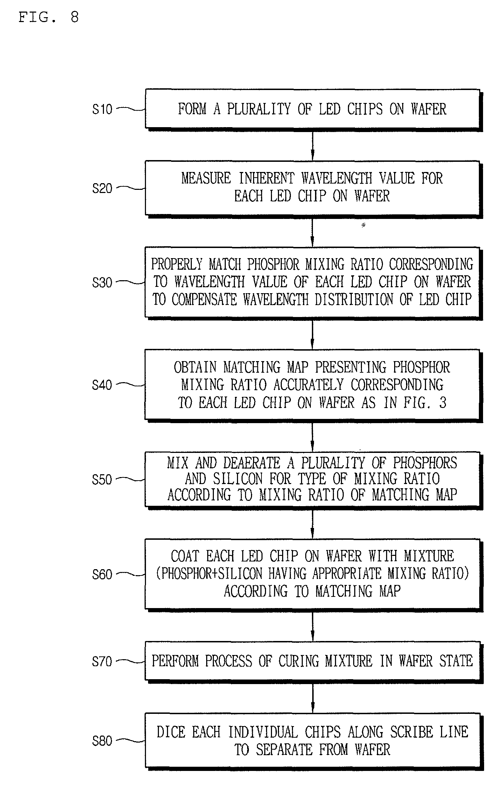

Hereinafter, a method of manufacturing a light emitting diode according to the fourth embodiment of the present invention is described in more detail with reference to Fig. 8 below.

First, a plurality of LED chips is formed on a wafer (S10). Herein, the LED may be a blue LED or ultra-violet (UV) LED emitting blue light or ultraviolet ray, respectively.

Next, an inherent wavelength value emitted from each LED chip on the wafer is measured (S20).

In order to compensate a wavelength distribution of the LED chip, a phosphor mixing ratio corresponding to the wavelength value of the each LED chip on the wafer is determined (S30). Herein, since the each LED formed by a semiconductor process in operation S10 does not output the same wavelength but has a wavelength distribution with an error, phosphor mixing ratios corresponding to the measured wavelengths of the individual chips are determined for photo converting the each individual chips to emit white light in the same color coordinate.

Next, as illustrated in Fig. 4, a matching map presenting a phosphor mixing ratio accurately corresponding to the measured wavelength value of each LED chip on the wafer is obtained (S40).

A plurality of phosphors and silicon are mixed for a type of mixing ratios according to the mixing ratios of the matching map and deaerated (S50).

Each LED chip on the wafer is coated with the fluorescent substance (phosphor+Si having an appropriate mixing ratio) mixed according to the matching map (S60).

The fluorescent substance is cured in a wafer state (S70).

The individual LED chip is diced along scribe lines on the wafer and is separated from the wafer (S80).

Herein, coating of the fluorescent substance after masking the scribe lines and the metal pads of the LED chip was described in the first to third embodiments and thus, the description thereof will be omitted.

## Claims

1. A method of manufacturing a light emitting diode (30), the method comprising:
measuring a light emitting diode at a stage of a wafer before each unit light emitting diode chip formed on the wafer is diced and separated; and further comprising:
performing conformal coating on the light emitting diode with a material having a phosphor mixing ratio based on the measured result, wherein the measuring comprises measuring a wavelength of light emitted by the light emitting diode(30), to convert light emitted from the light emitting diode to white light;
**characterized in that**:
the light emitting diode is multiply coated with phosphor material, each coat having different phosphor mixing ratios of yellow, green and red phosphors.

2. The method according to claim 1, wherein the light emitting diode (30) comprises at least any one of a blue light emitting diode or an ultraviolet light emitting diode.

3. The method according to claim 1 or claim 2, further comprising treating a region of the light emitting diode (30) on which the conformal coating is performed to prevent the coating penetrating the region.

4. The method according to claim 4, wherein the region is treated by using at least any one of a paraffin wax, a silk screen, and a photoresist.

5. A light emitting diode (30) comprising:
a light emitting part; and further comprising:
a conformal coating part coated on the light emitting part and having a phosphor mixing ratio based on a wavelength of light emitted from the light emitting part to convert the light emitted from the light emitting part to white light;
**characterized in that**:
the light emitting diode is configured to be multiply coated with phosphor material, each coat having different phosphor mixing ratios of yellow, green and red phosphors.

## Patentansprüche

1. Verfahren zur Herstellung einer Leuchtdiode (30), wobei das Verfahren Folgendes umfasst:
Messen einer Leuchtdiode an einer Waferstufe, bevor jede Leuchtdiodenchipeinheit, die auf dem Wafer ausgebildet wird, zerteilt und getrennt wird; und
ferner umfassend:
Durchführen einer konformen Beschichtung der Leuchtdiode mit einem Material, das ein Leuchtstoffmischverhältnis aufweist, das auf dem Messresultat basiert, wobei die Messung eine Messung einer von der Leuchtdiode (30) emittierten Lichtwellenlänge umfasst, um von der Leuchtdiode emittiertes Licht in weißes Licht umzuwandeln;
**dadurch gekennzeichnet, dass**
die Leuchtdiode mehrfach mit einem Leuchtstoffmaterial beschichtet wird, wobei jede Beschichtung unterschiedliche Leuchtstoffmischverhältnisse von gelbem, grünem und rotem Leuchtstoff aufweist.

2. Verfahren nach Anspruch 1, wobei die Leuchtdiode (30) eine blaues Licht emittierende Diode und/oder eine ultraviolettes Licht emittierende Diode umfasst.

3. Verfahren nach Anspruch 1 oder 2, ferner umfassend Behandeln eines Bereichs der Leuchtdiode (30), auf der die konforme Beschichtung durchgeführt wird, um zu verhindern, dass die Beschichtung den Bereich durchdringt.

4. Verfahren nach Anspruch 4, wobei der Bereich behandelt wird, indem ein Paraffinwachs und/oder eine Seidenabschirmung und/oder ein Photoresist verwendet wird.

5. Leuchtdiode (30), umfassend:
einen lichtemittierenden Teil; und
ferner umfassend:
einen konformen Beschichtungsteil, der auf den lichtemittierenden Teil aufgetragen ist und ein Leuchtstoffmischverhältnis aufweist, das auf einer von dem lichtemittierenden Teil emittierten Lichtwellenlänge basiert, um das von dem lichtemittierenden Teil emittierte Licht in weißes Licht umzuwandeln;
**dadurch gekennzeichnet, dass**
die Leuchtdiode so konfiguriert ist, dass sie mehrfach mit Leuchtstoffmaterial beschichtet ist, wobei jede Beschichtung unterschiedliche Leuchtstoffmischverhältnisse von gelbem, grünem und rotem Leuchtstoff aufweist.

## Revendications

1. Procédé de fabrication d'une diode électroluminescente (30), le procédé comprenant l'étape suivante :
mesurer une diode électroluminescente à l'étape de tranche avant que chaque puce unitaire de diode électroluminescente formée sur la tranche soit découpée en dés et séparée, et comprenant en outre l'étape suivante :
réaliser un revêtement enrobant sur la diode électroluminescente avec un matériau ayant un rapport de mélange de phosphore basé sur le résultat mesuré, où la mesure comprend de mesurer une longueur d'onde de la lumière émise par la diode électroluminescente (30) pour convertir la lumière émise par la diode électroluminescente en lumière blanche ;
**caractérisé en ce que** :
la diode électroluminescente est revêtue de plusieurs couches de matériau phosphorescent, chaque couche ayant différents rapports de mélange de phosphore de phosphores jaune, vert et rouge.

2. Procédé selon la revendication 1, dans lequel la diode électroluminescente (30) comprend au moins une diode quelconque parmi une diode électroluminescente bleue et une diode électroluminescente ultraviolette.

3. Procédé selon la revendication 1 ou la revendication 2, comprenant en outre de traiter une région de la diode électroluminescente (30) sur laquelle le revêtement enrobant est appliqué pour empêcher le revêtement de pénétrer dans la région.

4. Procédé selon la revendication 4, dans lequel la région est traitée en utilisant au moins un élément quelconque parmi de la paraffine, un écran de soie, et une résine photosensible.

5. Diode électroluminescente (30) comprenant :
une partie d'émission de lumière ; et
comprenant en outre :
une partie de revêtement enrobant appliquée sur la partie d'émission de lumière et ayant un rapport de mélange de phosphore basé sur une longueur d'onde de lumière émise par la partie d'émission de lumière pour convertir la lumière émise par la partie d'émission de lumière en lumière blanche ;
**caractérisée en ce que** :
la diode électroluminescente est configurée pour être revêtue de plusieurs couches de matériau phosphorescent, chaque couche ayant différents rapports de mélange de phosphore de phosphores jaune, vert et rouge.
